# FASCICULE DE BREVET EUROPEEN

(11) **EP 4 634 674 B1**
(45) Date de publication et mention de la délivrance du brevet: **16.09.2026**
(21) Numéro de dépôt: 23822427.3
(22) Date de dépôt: 15.11.2023
(51) Int. Cl.: G01R 31/36, G01R 31/367, G01R 31/3828, G01R 31/3842, G01R 31/396, B60L 58/12, B60L 58/16, B60L 58/21

(54) **ESTIMATION FIABLE DE L'ÉTAT DE CHARGE D'UNE BATTERIE CELLULAIRE D'UN VÉHICULE**
ZUVERLÄSSIGE SCHÄTZUNG DES LADEZUSTANDS EINER ZELLULAREN BATTERIE EINES FAHRZEUGS
RELIABLE ESTIMATION OF THE STATE OF CHARGE OF A CELLULAR BATTERY OF A VEHICLE

(30) Priorité: 16.12.2022 FR 2213504
(43) Date de publication de la demande: 22.10.2025
(73) Titulaire: Stellantis Auto SAS, 78300 Poissy (FR)
(72) Inventeur: MAWONOU, Kodjo Senou Rodolphe, 78370 Plaisir (FR); EDDAHECH, Akram, 78280 Guyancourt (FR); SHI, Zhihao, 78570 Andresy (FR); FATISIS, Konstantinos, 75003 Paris 03 (FR)
(74) Mandataire: PSIP
(86) Numéro de dépôt international: PCT/FR2023/051795
(87) Numéro de publication internationale: WO 2024/126909

(56) Documents cités:
- EP-A1- 3 045 925
- US-B2- 10 408 880

## Description

### Domaine technique de l'invention

L'invention concerne les véhicules comprenant au moins une batterie cellulaire rechargeable, et plus précisément l'estimation de l'état de charge en cours (ou SoC (« State of Charge »)) de telles batteries.

### Etat de la technique

Certains véhicules, éventuellement de type automobile, comprennent une batterie cellulaire rechargeable et constituant une batterie principale (ou de traction) du fait qu'elle est chargée d'alimenter au moins une machine motrice électrique de leur groupe motopropulseur (ou GMP).

Un procédé d'estimation d'un état de charge d'une batterie comprenant des cellules est connu du document EP 3045925 A1.

On entend ici par « batterie cellulaire » une batterie comportant de nombreuses cellules de stockage d'énergie électrique, éventuellement électrochimiques (par exemple de type lithium-ion (ou Li-ion) ou Ni-Mh ou Ni-Cd). Par exemple, une telle batterie cellulaire peut être de type basse ou moyenne tension (typiquement au moins 400 V).

Par ailleurs, on entend ici par « batterie » l'ensemble comprenant les cellules, une structure de support de ces cellules, un bac (ou boîtier) logeant la structure de support avec les éléments, ainsi que généralement un boîtier électronique de contrôle et protection.

Une telle batterie cellulaire est habituellement associée à un boîtier de batterie qui comprend des moyens de mesure de tension/courant/température interne et un calculateur de batterie. Ce dernier centralise les mesures de courant, les mesures de tension et les mesures de température interne (à l'intérieur de la batterie cellulaire), et détermine ou estime des paramètres de cette batterie cellulaire en fonction de ces mesures, et notamment sa résistance interne, sa tension minimale et son état de charge en cours (ou SoC (State of Charge)).

Cet état de charge (ou SoC) est un paramètre important dans un véhicule à GMP électrique car il permet d'estimer l'autonomie kilométrique de ce véhicule.

Au moins cinq techniques peuvent être mises en œuvre pour estimer le SoC d'une batterie (cellulaire).

Une première technique consiste à estimer le SoC de la batterie à l'aide du comptage des consommations (en Ah). Mais, se fier uniquement aux informations en cours n'est pas optimal en raison de l'accumulation des erreurs des capteurs de courant avec le temps et de l'impossibilité de corriger l'erreur de capacité lorsque la batterie vieillit.

Une deuxième technique consiste à estimer le SoC de la batterie au moyen d'un filtre de Kalman étendu (ou EKF (« Extended Kalman Filter »)) appliqué uniquement aux tensions minimales et maximales des cellules. Dans ce cas, les tensions des cellules de la batterie sont composées de la tension de circuit ouvert (ou OCV (« Open Circuit Voltage »)) et de la contribution de la résistance de courant continu (ou DCR (« Direct Current Resistance »)). Compte tenu du vieillissement et de la dispersion au sein de la batterie en début de vie, il est rare que la tension minimale (respectivement la tension maximale) conduise à un SoC minimum (respectivement un SoC maximum). Par conséquent, cette deuxième solution n'est pas précise et peut conduire à une mauvaise anticipation des limitations fonctionnelles pour les tensions des cellules de la batterie.

Une troisième technique consiste à estimer le SoC de la batterie au moyen du filtre de Kalman étendu (EKF) et de la technique dite des moindres carrés récursifs (ou RLS (« Recursive Least Square »)) appliqués à un modèle de circuit électrique équivalent (ou EEC (« Equivalent Electric Circuit »)) et un modèle d'hystérésis pour toutes les cellules de la batterie dans une même période d'échantillonnage. En estimant le SoC de chaque cellule de la batterie en utilisant à chaque fois un algorithme EKF/RLS, on peut rapidement atteindre les limites de capacité de calcul du calculateur de batterie, notamment lorsque le nombre de cellules est très important (typiquement pour une batterie de 800 V).

Une quatrième technique consiste à estimer le SoC de la batterie au moyen du filtre de Kalman étendu (EKF) et de la technique des moindres carrés récursifs (RLS) appliqués à un modèle de circuit électrique équivalent (EEC) et un modèle d'hystérésis pour des lots de cellules de la batterie avec une approche séquentielle pour s'adapter aux contraintes de calcul du calculateur de batterie. Cette technique est une version améliorée de la troisième technique qui ne résout pas complètement le problème car la charge de calcul augmentera encore avec le nombre de cellules mais seulement moins qu'auparavant.

Une cinquième technique consiste à estimer le SoC de la batterie au moyen d'une cellule moyenne virtuelle en utilisant la valeur moyenne des tensions des cellules et en calculant le SoC de la cellule moyenne virtuelle et déduisant le SoC de toutes les cellules de la batterie en calculant les différences de SoC de chaque cellule par rapport à la cellule moyenne virtuelle. Cela est efficace et permet de réduire considérablement la charge de calcul du calculateur de batterie. Cependant, la cellule moyenne virtuelle est difficile à définir et ne correspond à aucune réalité physique. De ce fait, d'importantes erreurs d'estimation du SoC peuvent survenir, ce qui est problématique, notamment pour de faibles valeurs de SoC et/ou en présence de basses températures pour lesquelles les valeurs des résistances de courant continu internes (DCR) varient considérablement.

Il n'existe donc pas de technique connue permettant d'estimer de façon suffisamment précise avec un calculateur de batterie classique le SoC d'une batterie comportant un grand nombre de cellules.

L'invention a donc notamment pour but d'améliorer la situation.

### Présentation de l'invention

Elle propose notamment à cet effet un procédé d'estimation d'un état de charge d'une batterie comprenant N cellules et équipant un véhicule.

Ce procédé d'estimation se caractérise par le fait qu'il comprend une étape dans laquelle :
- on identifie parmi les N cellules M cellules dites critiques, puis
- on détermine pour chacune de ces M cellules critiques identifiées et selon une première période d'échantillonnage, un état de charge par application à un modèle de cellule choisi d'un premier filtre choisi utilisant des impédance et capacité mesurées de la cellule considérée, puis on sélectionne une cellule dite nominale parmi les M cellules critiques identifiées, puis
- pour chacune des N-M cellules non critiques, on détermine, selon une seconde période d'échantillonnage supérieure à la première période d'échantillonnage et par application au modèle de cellule choisi d'un second filtre choisi, une nouvelle différence d'état de charge fonction d'une précédente différence d'état de charge, d'un courant mesuré dans la batterie, d'une capacité mesurée de la cellule non critique considérée et de la capacité mesurée de la cellule nominale, puis un nouvel état de charge en sommant l'état de charge déterminé de la cellule nominale et la nouvelle différence d'état de charge, et
- on détermine selon cette seconde période d'échantillonnage l'état de charge de la batterie en exploitant les nouveaux états de charge déterminés des N-M cellules non critiques et les états de charge déterminés des M cellules critiques.

Grâce à l'invention, on peut réduire notablement la charge de calcul du dispositif d'estimation tout en garantissant une estimation précise et très rapide des états de charge des M cellules les plus critiques à chaque première période d'échantillonnage et en assurant une estimation rapide et précise des états de charge des N-M cellules non critiques restantes et de l'état de charge de la batterie cellulaire à chaque seconde période d'échantillonnage.

Le procédé d'estimation selon l'invention peut comporter d'autres caractéristiques qui peuvent être prises séparément ou en combinaison, et notamment :
- dans son étape, le premier filtre choisi peut être un filtre de Kalman étendu (ou EKF) à deux états, un premier état étant l'état de charge de la cellule critique considérée et un second état étant une tension de polarisation de la cellule critique considérée ;
- dans son étape, le second filtre choisi peut être un filtre de Kalman étendu (ou EKF) à un état, cet état étant l'état de charge de la cellule non critique considérée ;
- dans son étape le modèle de cellule choisi peut être un modèle de circuit électrique équivalent n-RC, avec n ≥ 1 ;
- dans son étape, on peut utiliser une seconde période d'échantillonnage qui est égale à K fois la première période d'échantillonnage, où K est un nombre de groupes dans lesquels les N-M cellules non critiques sont réparties, et on peut déterminer lors de chaque première période d'échantillonnage les nouveaux états de charge des cellules non critiques de l'un des K groupes de manière à disposer des N-M nouveaux états de charge des N-M cellules non critiques à la fin de chaque seconde période d'échantillonnage ;
- dans son étape, on peut sélectionner les M cellules critiques en déterminant parmi les N cellules celles qui ont les M/2 limites de fonctionnement supérieures les plus grandes et celles qui ont les M/2 limites de fonctionnement inférieures les plus petites par rapport à des limites de fonctionnement prédéfinies ;
- en présence de la dernière option, dans son étape, on peut déterminer parmi les M/2 cellules critiques ayant les M/2 limites de fonctionnement supérieures les plus grandes et parmi les M/2 cellules critiques ayant les M/2 limites de fonctionnement inférieures les plus petites celle qui est la plus critique et qui devient la cellule nominale.

L'invention propose également un produit programme d'ordinateur comprenant un jeu d'instructions qui, lorsqu'il est exécuté par des moyens de traitement, conduisent ceux-ci à mettre en œuvre un procédé d'estimation du type de celui présenté ci-avant, dans un véhicule comprenant une batterie comportant N cellules, pour estimer un état de charge de cette batterie.

L'invention propose également un dispositif d'estimation d'état de charge destiné à équiper un véhicule comprenant une batterie comportant N cellules.

Ce dispositif d'estimation se caractérise par le fait qu'il comprend au moins un processeur et au moins une mémoire agencés pour effectuer les opérations consistant :
- à identifier parmi les N cellules M cellules dites critiques, puis
- à déterminer pour chacune de ces M cellules critiques identifiées et selon une première période d'échantillonnage, un état de charge par application à un modèle de cellule choisi d'un premier filtre choisi utilisant des impédance et capacité mesurées de la cellule considérée, puis à sélectionner une cellule dite nominale parmi les M cellules critiques identifiées, puis
- pour chacune des N-M cellules non critiques, à déterminer, selon une seconde période d'échantillonnage supérieure à la première période d'échantillonnage et par application au modèle de cellule choisi d'un second filtre choisi, une nouvelle différence d'état de charge fonction d'une précédente différence d'état de charge, d'un courant mesuré dans la batterie, d'une capacité mesurée de la cellule non critique considérée et de la capacité mesurée de la cellule nominale, puis un nouvel état de charge en sommant l'état de charge déterminé de la cellule nominale et la nouvelle différence d'état de charge, et
- à déterminer selon cette seconde période d'échantillonnage l'état de charge de la batterie en exploitant les nouveaux états de charge déterminés des N-M cellules non critiques et les états de charge déterminés des M cellules critiques.

L'invention propose également un véhicule, éventuellement de type automobile, et comprenant, d'une part, une batterie comportant N cellules, et, d'autre part, un dispositif d'estimation du type de celui présenté ci-avant.

### Brève description des figures

D'autres caractéristiques et avantages de l'invention apparaîtront à l'examen de la description détaillée ci-après, et des dessins annexés, sur lesquels :
[Fig. 1] illustre schématiquement et fonctionnellement un exemple de réalisation d'un véhicule comprenant une chaîne de transmission à GMP à machine motrice électrique associée à une batterie cellulaire et associée à un calculateur de batterie, et un dispositif d'estimation selon l'invention,
[Fig. 2] illustre schématiquement et fonctionnellement un exemple de réalisation d'un calculateur de batterie comprenant un exemple de réalisation d'un dispositif d'estimation selon l'invention, et
[Fig. 3] illustre schématiquement un exemple d'algorithme mettant en œuvre un procédé d'estimation selon l'invention.

### Description détaillée de l'invention

L'invention a notamment pour but de proposer un procédé d'estimation, et un dispositif d'estimation DE associé, destinés à permettre l'estimation de l'état de charge en cours (ou SoC (State of Charge)) d'une batterie cellulaire d'un véhicule V.

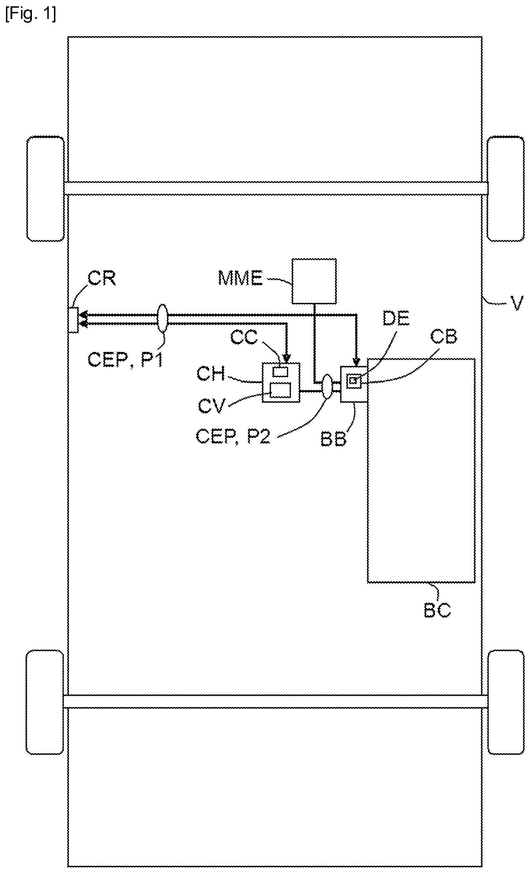

Dans ce qui suit, on considère, à titre d'exemple non limitatif, que le véhicule V est de type automobile. Il s'agit par exemple d'une voiture, comme illustré sur la figure 1. Mais l'invention n'est pas limitée à ce type de véhicule. Elle concerne en effet tout type de véhicule comprenant une batterie cellulaire dont on veut estimer l'état de charge. Ainsi, elle concerne les véhicules terrestres (véhicules utilitaires, camping-cars, minibus, cars, camions, motocyclettes, engins de voirie, engins de chantier, engins agricoles, engins de loisir (motoneige, kart), engins à chenille(s), les trains et les tramways, par exemple), les aéronefs et les bateaux.

Par ailleurs, on considère dans ce qui suit, à titre d'exemple non limitatif, que le véhicule V comprend une chaîne de transmission à groupe motopropulseur (ou GMP) de type tout électrique (et donc dont la motricité est assurée exclusivement par au moins une machine motrice électrique MME). Mais le GMP pourrait être de type hybride (thermique et électrique).

On a schématiquement représenté sur la figure 1 un véhicule V comprenant une chaîne de transmission à GMP électrique (et donc à machine motrice électrique MME), une batterie cellulaire BC associée à un calculateur de batterie CB, un circuit électrique principal CEP connecté à un connecteur de recharge CR, un chargeur CH, un convertisseur CV, et un dispositif d'estimation DE selon l'invention.

Le circuit électrique principal (ou « haute tension ») CEP est connecté, d'une part, à la batterie cellulaire BC, et, d'autre part, à des équipements électroniques, comme par exemple le convertisseur CV et la machine motrice électrique MME. Il permet aussi la recharge de la batterie cellulaire BC par de l'énergie électrique issue d'une source d'alimentation externe et connectée temporairement au connecteur de recharge CR du véhicule V. Ce circuit électrique principal CEP comprend donc au moins un circuit d'alimentation P1 assurant le couplage entre la batterie cellulaire BC et au moins les machine motrice électrique MME et convertisseur CV, et un circuit de recharge P2 connecté au connecteur de recharge CR et permettant de recharger la batterie cellulaire BC lorsque ce dernier (CR) est temporairement connecté à une source d'alimentation externe.

Dans l'exemple illustré non limitativement sur la figure 1 le circuit de recharge P2 permet de recharger la batterie cellulaire BC non seulement en courant continu (ou mode 4), mais aussi en courant alternatif (ou mode 2 ou 3), sous le contrôle d'au moins un calculateur de chargeur CC (faisant ici partie du chargeur CH et gérant notamment les échanges d'informations avec la source d'alimentation externe pendant une phase de recharge).

Mais dans des variantes de réalisation non illustrées, le circuit de recharge P2 pourrait ne permettre que les recharges en courant continu (ou mode 4) ou bien que les recharges en courant alternatif (ou mode 2 ou 3). Il est rappelé que les recharges en courant alternatif se font via le convertisseur CV.

On notera, comme illustré non limitativement sur la figure 1, que le convertisseur CV peut faire partie du chargeur CH.

La chaîne de transmission a un GMP qui est, ici, purement électrique et donc qui comprend, notamment, une machine motrice électrique MME. On entend ici par « machine motrice électrique » une machine électrique agencée de manière à fournir du couple pour déplacer le véhicule V lorsqu'elle est alimentée en énergie électrique, ainsi qu'éventuellement à récupérer du couple dans la chaîne de transmission.

La machine motrice électrique MME (ici un moteur électrique) est ici couplée à la batterie cellulaire BC via le circuit d'alimentation P1 du circuit électrique principal CEP, afin d'être alimentée en énergie électrique, ainsi qu'éventuellement d'alimenter cette batterie cellulaire BC en énergie électrique, par exemple lors d'une phase de freinage récupératif.

La batterie cellulaire BC alimentant ici la machine motrice électrique MME, elle constitue une batterie principale (ou de traction). Elle comprend N cellules de stockage d'énergie électrique (non illustrées), éventuellement électrochimiques (par exemple de type lithium-ion (ou Li-ion) ou Ni-Mh ou Ni-Cd). Egalement par exemple, la batterie cellulaire BC peut être de type basse tension (typiquement 450 V), ou moyenne tension (typiquement de 600 V à 1000 V). Mais elle pourrait être de type haute tension. On notera que l'invention est d'autant plus utile que le nombre N de cellules est grand (et notamment supérieur à 100).

Comme évoqué plus haut, l'invention propose notamment un procédé d'estimation destiné à permettre l'estimation de l'état de charge SoC^{BC} de la batterie BC du véhicule V.

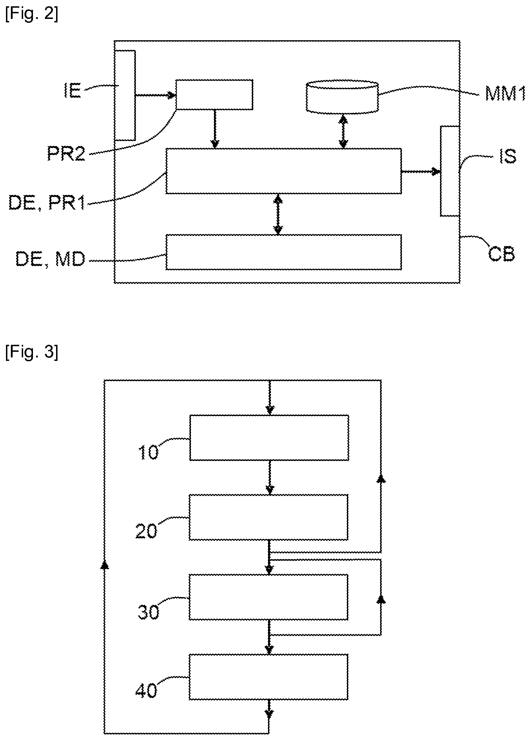

Ce procédé (d'estimation) peut être mis en œuvre au moins partiellement par le dispositif d'estimation DE (illustré au moins partiellement sur les figures 1 et 2) qui comprend à cet effet au moins un processeur PR1, par exemple de signal numérique (ou DSP (« Digital Signal Processor »)), et au moins une mémoire MD. Ce dispositif d'estimation DE peut donc être réalisé sous la forme d'une combinaison de circuits ou composants électriques ou électroniques (ou « hardware ») et de modules logiciels (ou « software »). A titre d'exemple, il peut s'agir d'un microcontrôleur.

La mémoire MD est vive afin de stocker des instructions pour la mise en œuvre par le processeur PR1 d'une partie au moins du procédé d'estimation. Le processeur PR1 peut comprendre des circuits intégrés (ou imprimés), ou bien plusieurs circuits intégrés (ou imprimés) reliés par des connections filaires ou non filaires. On entend par circuit intégré (ou imprimé) tout type de dispositif apte à effectuer au moins une opération électrique ou électronique.

Dans l'exemple illustré non limitativement sur les figures 1 et 2, le dispositif d'estimation DE fait partie du calculateur de batterie CB. Mais cela n'est pas obligatoire. En effet, le dispositif d'estimation DE pourrait comprendre son propre calculateur dédié, lequel est alors couplé au calculateur de batterie CB, ou bien pourrait faire partie d'un autre calculateur embarqué dans le véhicule V, par exemple.

Comme illustré non limitativement sur la figure 3, le procédé (d'estimation), selon l'invention, comprend une étape 10-40 qui est mise en œuvre au moins chaque fois que le véhicule V est utilisé (et en particulier chaque fois que son GMP est en fonctionnement).

L'étape 10-40 du procédé comprend tout d'abord une sous-étape 10 dans laquelle on (le dispositif d'estimation DE) identifie parmi les N cellules de la batterie cellulaire BC M cellules dites critiques. On comprendra que M est strictement inférieur à N (par exemple, M peut être compris entre N/20 et N/5). On comprendra également que les N-M cellules restantes sont dites non critiques.

Par exemple, dans la sous-étape 10 on (le dispositif d'estimation DE) peut sélectionner les M cellules critiques en déterminant parmi les N cellules celles qui ont les M/2 limites de fonctionnement supérieures les plus grandes et celles qui ont les M/2 limites de fonctionnement inférieures les plus petites par rapport à des limites de fonctionnement prédéfinies (par le fabricant de la batterie cellulaire BC).

Plusieurs limites de fonctionnement prédéfinies peuvent être utilisées. Dans ce qui suit, on considère, à titre d'exemple non limitatif, que les limites de fonctionnement sont relatives aux états de charge (ou SoCs) respectifs des M cellules critiques. On notera que les états de charge minimaux et/ou maximaux qui sont utilisés pour déterminer initialement les limites fonctionnelles peuvent être déduits de mesures de tension effectuées sur les cellules et plus précisément des mesures des tensions de circuit ouvert (ou OCV).

Mais les limites de fonctionnement pourraient être relatives aux capacités (respectivement SOHC (« State Of Health of Capacity » - état de santé en capacité)), ou impédances (respectivement SOHR (« State Of Health of Resistance » - état de santé résistif)), ou températures internes respectives des M cellules critiques. Dans ce cas, elles découlent de mesures de capacités ou d'impédances (ou résistances).

L'étape 10-40 du procédé comprend aussi une sous-étape 20 dans laquelle on (le dispositif d'estimation DE) détermine selon une première période d'échantillonnage Tₛ₁ au moins un état de charge SoC'(k) (ainsi qu'éventuellement une tension de polarisation Vⁱ_{RC}) pour chacune des M cellules critiques identifiées et désignées par l'exposant i. A cet effet, on (le dispositif d'estimation DE) applique à un modèle de cellule choisi un premier filtre choisi qui utilise les impédance Zᵢ et capacité Capai mesurées de la cellule critique i considérée.

Les paramètres de chaque cellule (et en particulier des cellules critiques), et notamment l'impédance et la capacité, sont ici considérés comme disponibles au sein du véhicule V, et donc les moyens mis en œuvre pour les obtenir ne sont pas décrits ci-après.

Par exemple, la première période d'échantillonnage Tₛ₁ peut être comprise entre 10 ms et 200 ms. A titre d'exemple illustratif, la première période d'échantillonnage Tₛ₁ peut être égale à 100 ms.

Dans la sous-étape 20, on (le dispositif d'estimation DE) sélectionne aussi une cellule dite nominale parmi les M cellules critiques identifiées dans la sous-étape 10.

Par exemple, dans la sous-étape 20 on (le dispositif d'estimation DE) peut déterminer parmi les M/2 cellules critiques ayant les M/2 limites de fonctionnement supérieures les plus grandes et parmi les M/2 cellules critiques ayant les M/2 limites de fonctionnement inférieures les plus petites celle qui est la plus critique. Dans ce cas, la cellule qui est la plus critique parmi les M devient la cellule nominale et correspond à la réalité physique en cours dans la batterie cellulaire BC pour la première période d'échantillonnage Tₛ₁ considérée.

L'étape 10-40 du procédé comprend aussi une sous-étape 30 dans laquelle on (le dispositif d'estimation DE) détermine pour chacune des N-M cellules non critiques, selon une seconde période d'échantillonnage Tₛ₂, supérieure à la première période d'échantillonnage Tₛ₁, et par application au modèle de cellule choisi d'un second filtre choisi, une nouvelle différence d'état de charge ΔSoC^{j}(k). L'exposant j désigne ici l'une des N-M cellules non critiques. Chaque différence d'état de charge ΔSoC^{j}(k) d'une cellule non critique j est fonction de la précédente (et donc dernière) différence d'état de charge ΔSoC^{j}(k-1), du courant I mesuré dans la batterie cellulaire BC (c'est-à-dire le courant qui la traverse), de la capacité Capa^{j} mesurée de la cellule non critique j considérée et de la capacité Capa^{nom} mesurée de la cellule nominale.

Ensuite, dans cette sous-étape 30 on (le dispositif d'estimation DE) détermine toujours pour chacune des N-M cellules non critiques, selon la seconde période d'échantillonnage Tₛ₂, un nouvel état de charge SoC^{j}(k) en sommant l'état de charge déterminé de la cellule nominale SoC^{nom}(k) et la nouvelle différence d'état de charge ΔSoC^{j}(k), soit SoC^{j}(k) = SoC^{nom}(k) + ΔSoC^{j}(k).

L'étape 10-40 du procédé comprend aussi une sous-étape 40 dans laquelle on (le dispositif d'estimation DE) détermine selon la seconde période d'échantillonnage Tₛ₂ l'état de charge SoC^{BC} de la batterie BC en exploitant les nouveaux états de charge déterminés SoC^{j}(k) des N-M cellules non critiques et les états de charge déterminés SoCⁱ(k) des M cellules critiques.

En d'autres termes, seules M cellules critiques i (i = 1 à M) font l'objet de calculs de leur état de charge SoCⁱ(k) (ainsi qu'éventuellement de leur tension de polarisation Vⁱ_{RC}) avec un premier filtre et selon la première période d'échantillonnage Tₛ₁, tandis que les N-M cellules non critiques j (j = 1 à N-M) restantes font l'objet de calculs d'au moins leur état de charge SoC^{j}(k) moins fréquents selon la seconde période d'échantillonnage Tₛ₂ (> Tₛ₁), ce qui permet d'obtenir une estimation de l'état de charge SoC^{BC} de la batterie cellulaire BC à chaque seconde période d'échantillonnage Tₛ₂. Cela permet de surveiller étroitement les M cellules critiques à l'aide de modèles de batterie cellulaire plus complets avec de nombreux états pour obtenir une précision et une fiabilité élevées et de réduire notablement la charge de calcul (ou CPU) du dispositif d'estimation DE (et donc ici du calculateur de batterie CB), tout en garantissant une estimation précise et très rapide des états de charge SoCⁱ(k) des M cellules les plus critiques à chaque première période d'échantillonnage Tₛ₁ et en assurant une estimation rapide et précise des états de charge SoC^{j}(k) des N-M cellules non critiques restantes et de l'état de charge SoC^{BC} de la batterie cellulaire BC à chaque seconde période d'échantillonnage Tₛ₂.

En attendant un rafraichissement complet de l'état de charge des N-M cellules non critiques qui se fait tous les Tₛ₂ avec la résolution entière du second filtre, l'état de charge des N-M cellules non critiques peut continuer à être mis à jour tous les Tₛ₁ avec l'équation SoC^{j}(k) = SoC^{nom}(k) + ΔSoC^{j}(antérieur), où ΔSoC^{j}(antérieur) est l'écart de SOC correspondant au dernier instant multiple de Tₛ₂ (c'est-à-dire l'écart de SOC séparant l'état de charge de la cellule non critique (j) de celui de l'état de charge de la cellule nominale). Ainsi on peut aussi profiter en permanence toutes les premières périodes d'échantillonnage Tₛ₁ de la mise à jour du SoC^{nom} de la cellule nominale, et on peut venir optimiser cela avec le second filtre chaque seconde période d'échantillonnage Tₛ₂.

Ainsi on en profite en permanence tous les Ts1 de la mise à jour du SOC de la cellule nominale et on vient optimiser cela avec le deuxième filtre chaque Ts2.

Par exemple, dans la sous-étape 20 de l'étape 10-40, le premier filtre choisi peut être un filtre de Kalman étendu (ou EKF) à deux états. Dans ce cas, le premier état peut être l'état de charge SoCⁱ(k) de la cellule critique i considérée et le second état peut être la tension de polarisation Vⁱ_{RC} de la cellule critique i considérée. Mais cela n'est pas obligatoire. En effet, d'autres premiers filtres à au moins deux états peuvent être utilisés, dès lors qu'au moins deux de ces états sont l'état de charge SoCⁱ(k) et la tension de polarisation Vⁱ_{RC}.

Egalement par exemple, dans la sous-étape 30 de l'étape 10-40, le second filtre choisi peut être un filtre de Kalman étendu (ou EKF) à un état. Dans ce cas, l'unique état peut être l'état de charge SoC^{j}(k) de la cellule non critique j considérée. Mais cela n'est pas obligatoire. En effet, d'autres seconds filtres à un état peuvent être utilisés.

Egalement par exemple, dans les sous-étapes 20 et 30 de l'étape 10-40, le modèle de cellule choisi peut être un modèle de circuit électrique équivalent n-RC, avec n ≥ 1, bien connu de l'homme de l'art. Ainsi, on pourra utiliser un modèle de circuit électrique équivalent 1-RC ou, pour améliorer la précision, un modèle de circuit électrique équivalent 2-RC et plus généralement un modèle de circuit électrique équivalent n-RC (avec n ≥ 2). On peut aussi adjoindre à un modèle de circuit électrique équivalent n-RC (avec n ≥ 1) un modèle d'hystérésis simple pour augmenter la précision des estimations des états de charge, en particulier en présence de courbes plates SoC-OCV autour de 60% à 30 % de SoC pour les cellules de type LFP (« Lithium Fer Phosphate » ou (LiFePO₄)).

Il est rappelé que dans un modèle de circuit électrique équivalent 1-RC la cellule est électriquement représentée par une résistance R0 montée en série avec un ensemble comprenant une résistance R1 montée en parallèle avec une capacité.

Egalement par exemple, et comme illustré non limitativement sur la figure 3, dans la sous-étape 30 de l'étape 10-40 on (le dispositif d'estimation DE) peut utiliser une seconde période d'échantillonnage Tₛ₂ qui est égale à K fois la première période d'échantillonnage Tₛ₁, où K est un nombre de groupes dans lesquels les N-M cellules non critiques sont réparties. Dans ce cas, et comme illustré non limitativement sur la figure 3, on (le dispositif d'estimation DE) peut déterminer lors de chaque première période d'échantillonnage les nouveaux états de charge des cellules non critiques j de l'un des K groupes de manière à disposer des N-M nouveaux états de charge SoC^{j}(k) des N-M cellules non critiques j à la fin de chaque seconde période d'échantillonnage Tₛ₂.

On comprendra qu'ainsi, lors de chaque nouvelle première période d'échantillonnage Tₛ₁ on met à jour les états de charge SoC^{j} des cellules non critiques j de l'un des K groupes. Par conséquent, après K premières périodes d'échantillonnage Tₛ₁ successives, on dispose d'une mise à jour de tous les états de charge SoC^{j} des N-M cellules non critiques j que l'on peut alors exploiter avec les états de charge SoCⁱ des M cellules critiques obtenus lors de la toute dernière première période d'échantillonnage Tₛ₁, pour obtenir l'estimation de l'état de charge SoC^{BC} de la batterie cellulaire BC pour la seconde période d'échantillonnage Tₛ₂ venant de s'écouler.

Un tel traitement par groupes de cellules non critiques j lors de chaque première période d'échantillonnage Tₛ₁ permet avantageusement de réduire encore plus la quantité de ressources de calcul devant être utilisée.

Il est important de noter qu'à chaque première période d'échantillonnage Tₛ₁ on effectue une nouvelle sélection de M cellules critiques, et donc les M cellules critiques peuvent varier d'une première période d'échantillonnage Tₛ₁ à une autre. De même, à chaque première période d'échantillonnage Tₛ₁ on effectue une nouvelle sélection d'une cellule nominale et donc la cellule nominale peut varier d'une première période d'échantillonnage Tₛ₁ à une autre.

On décrit ci-après une mise en œuvre de l'invention au moyen d'équations, lorsque le premier filtre est un filtre de Kalman étendu (ou EKF) à deux états, le second filtre est un filtre de Kalman étendu (ou EKF) à un état, et le modèle de cellule est un modèle de circuit électrique équivalent 1-RC.

Après la sélection des M cellules critiques i parmi les N cellules de la batterie cellulaire BC, on applique au modèle de cellule, pour chacune de ces M cellules critiques i, un premier filtre EKF à deux états à l'aide des équations d'état suivantes des état de charge SoC'(k) et tension de polarisation Vⁱ_{RC} : $\left\{\begin{matrix}\left(\begin{matrix}{SoC}^{i} \left[k\right] \\ {V}_{RC}^{i} \left[k\right]\end{matrix}\right) = \left[\begin{matrix}1 & 0 \\ 0 & 1 - \frac{{T}_{s 1}}{{τ}_{1}^{i}}\end{matrix}\right] \left(\begin{matrix}{SoC}^{i} \left[k-1\right] \\ {V}_{RC}^{i} \left[k-1\right]\end{matrix}\right) + \left[\begin{matrix}\frac{{T}_{s 1}}{3600 \times {Capa}^{i}} \\ {R}_{1}^{i} \frac{{T}_{s 1}}{{τ}_{1}^{i}}\end{matrix}\right] I \left[k-1\right] \\ {V}_{t}^{i} \left[k\right] = OCV \left({SoC}^{i}\left[k\right]\right) + {V}_{RC}^{i} \left[k\right] + I \left[k\right] \times {R}_{0}^{i}\end{matrix}\right.$
où i ∈ {1, 2,..., M}, OCV est la tension en circuit ouvert (qui dépend du SoC et peut également dépendre de la température interne et du vieillissement), ${V}_{t}^{i} \left[k\right]$ est la tension aux bornes de la cellule i, Rⁱ₀ et Rⁱ₁ sont les résistances du modèle de circuit électrique équivalent 1-RC, ${τ}_{1}^{i}$ est une constante de temps prédéfinie, et I est le courant circulant dans la batterie cellulaire BC.

Pour déterminer les états de charge *SoCⁱ*[*k*] et tensions de polarisation ${V}_{RC}^{i} \left[k\right]$ des M cellules critiques i, on peut utiliser les équations suivantes : ${SoC}_{f}^{i} = {SoC}_{0}^{i} + {\int }_{0}^{{t}_{f}} \frac{I \left(t\right)}{{Capa}^{i}} dt$ $\begin{matrix}{V}_{RC}^{i} \left[k\right] = \left(1-\frac{{T}_{s 1}}{{τ}_{1}^{i}}\right) \left({V}_{t}\left[k-1\right]-OCV\left({SoC}^{i}\left[k-1\right]\right)-{R}_{0}^{i}I\left[k-1\right]\right) \\ + {R}_{1}^{i} \frac{{T}_{s 1}}{{τ}_{1}^{i}} I \left[k\right]\end{matrix}$

Ensuite, la cellule nominale est sélectionnée parmi les M cellules critiques identifiées. Puis, on détermine l'état de charge *SoC^{j}*[*k*] de chacune des N-M cellules non critiques restantes à l'aide des équations suivantes :
$Δ {SoC}^{j} \left[k\right] = {SoC}^{j} \left[k\right] - {SoC}^{nom} \left[k\right]$ $\left\{\begin{matrix}Δ {SoC}^{j} \left[k\right] = Δ {SoC}^{j} \left[k-1\right] + \frac{{T}_{s 1} \times I \left[k-1\right]}{3600} \left(\frac{1}{{Capa}^{j}}-\frac{1}{{Capa}^{nom}}\right) \\ {V}_{t}^{j} \left[k\right] = OCV \left({SoC}^{j}\left[k\right]\right) + {V}_{RC}^{j} \left[k\right] - {R}_{0}^{j} I \left[k\right]\end{matrix}\right.$
où *j* ∈ {1, 2, *...* , *N - M*}*.*

On peut aussi déterminer la tension de polarisation ${V}_{RC}^{j} \left[k\right]$ de chacune des N-M cellules non critiques restantes à l'aide des équations suivantes : $\begin{matrix}{V}_{RC}^{j} \left[k\right] = \left(1-\frac{{T}_{s 1}}{{τ}_{1}^{j}}\right) \left({V}_{t}^{j}\left[k-1\right]-OCV\left({SoC}^{j}\left[k-1\right]\right)-{R}_{0}^{j}I\left[k-1\right]\right) \\ + {R}_{1}^{j} \frac{{T}_{s 1}}{{τ}_{1}^{j}} I \left[k\right]\end{matrix}$

La dernière équation est une approximation obtenue en utilisant l'équation suivante avec la tension finale ${V}_{t}^{j} \left[k-1\right]$ :
${V}_{RC} \left[k\right] = \left(1-\frac{{T}_{s 1}}{{τ}_{1}}\right) {V}_{RC} \left[k-1\right] + {R}_{1} \frac{{T}_{s 1}}{{τ}_{1}} I \left[k\right]$

On notera également, comme illustré non limitativement sur la figure 2, que le calculateur de batterie CB (ou le calculateur du dispositif d'estimation DE) peut aussi comprendre une mémoire de masse MM1, notamment pour stocker les paramètres mesurés (ou estimés) des cellules, ainsi que d'éventuelles données intermédiaires intervenant dans tous ses calculs et traitements. Par ailleurs, ce calculateur de batterie CB (ou le calculateur du dispositif d'estimation DE) peut aussi comprendre une interface d'entrée IE pour la réception d'au moins les paramètres mesurés (ou estimés) des cellules et les demandes d'estimation de l'état de charge SoC^{BC} de la batterie cellulaire BC pour les utiliser dans des calculs ou traitements, éventuellement après l'avoir mis en forme et/ou démodulés et/ou amplifiés, de façon connue en soi, au moyen d'un processeur de signal numérique PR2. De plus, ce calculateur de batterie CB (ou le calculateur du dispositif d'estimation DE) peut aussi comprendre une interface de sortie IS, notamment pour délivrer un message contenant l'estimation de l'état de charge SoC^{BC} de la batterie cellulaire BC.

On notera également que l'invention propose aussi un produit programme d'ordinateur (ou programme informatique) comprenant un jeu d'instructions qui, lorsqu'il est exécuté par des moyens de traitement de type circuits électroniques (ou hardware), comme par exemple le processeur PR1, conduisent ceux-ci à mettre en œuvre le procédé d'estimation décrit ci-avant pour estimer dans le véhicule V l'état de charge SoC^{BC} de la batterie cellulaire BC.

## Revendications

1. Procédé d'estimation d'un état de charge d'une batterie (BC) comprenant N cellules et équipant un véhicule (V), le procédé comprenant une étape (10-40) dans laquelle i) on identifie parmi lesdites N cellules M cellules dites critiques, puis ii) on détermine pour chacune desdites M cellules critiques identifiées et selon une première période d'échantillonnage, un état de charge par application à un modèle de cellule choisi d'un premier filtre choisi utilisant des impédance et capacité mesurées de la cellule considérée, puis on sélectionne une cellule dite nominale parmi lesdites M cellules critiques identifiées, puis iii) pour chacune des N-M cellules non critiques, on détermine, selon une seconde période d'échantillonnage supérieure à ladite première période d'échantillonnage et par application audit modèle de cellule choisi d'un second filtre choisi, une nouvelle différence d'état de charge fonction d'une précédente différence d'état de charge, d'un courant mesuré dans ladite batterie (BC), d'une capacité mesurée de la cellule non critique considérée et de la capacité mesurée de ladite cellule nominale, puis un nouvel état de charge en sommant ledit état de charge déterminé de ladite cellule nominale et ladite nouvelle différence d'état de charge, et iv) on détermine selon ladite seconde période d'échantillonnage ledit état de charge de la batterie (BC) en exploitant lesdits nouveaux états de charge déterminés des N-M cellules non critiques et lesdits états de charge déterminés des M cellules critiques.

2. Procédé selon la revendication 1, **caractérisé en ce que** dans ladite étape (10-40) ledit premier filtre choisi est un filtre de Kalman étendu à deux états, un premier état étant l'état de charge de la cellule critique considérée et un second état étant une tension de polarisation de la cellule critique considérée.

3. Procédé selon la revendication 1 ou 2, **caractérisé en ce que** dans ladite étape (10-40) ledit second filtre choisi est un filtre de Kalman étendu à un état, cet état étant l'état de charge de la cellule non critique considérée.

4. Procédé selon l'une des revendications 1 à 3, **caractérisé en ce que** dans ladite étape (10-40) ledit modèle de cellule choisi est un modèle de circuit électrique équivalent n-RC, avec n ≥ 1.

5. Procédé selon l'une des revendications 1 à 4, **caractérisé en ce que** dans ladite étape (10-40) on utilise une seconde période d'échantillonnage égale à K fois ladite première période d'échantillonnage, où K est un nombre de groupes dans lesquels lesdites N-M cellules non critiques sont réparties, et on détermine lors de chaque première période d'échantillonnage les nouveaux états de charge des cellules non critiques de l'un desdits K groupes de manière à disposer desdits N-M nouveaux états de charge desdites N-M cellules non critiques à la fin de chaque seconde période d'échantillonnage.

6. Procédé selon l'une des revendications 1 à 5, **caractérisé en ce que** dans ladite étape (10-40) on sélectionne lesdites M cellules critiques en déterminant parmi lesdites N cellules celles qui ont les M/2 limites de fonctionnement supérieures les plus grandes et celles qui ont les M/2 limites de fonctionnement inférieures les plus petites par rapport à des limites de fonctionnement prédéfinies.

7. Procédé selon la revendication 6, **caractérisé en ce que** dans ladite étape (10-40) on détermine parmi lesdites M/2 cellules critiques ayant lesdites M/2 limites de fonctionnement supérieures les plus grandes et parmi lesdites M/2 cellules critiques ayant lesdites M/2 limites de fonctionnement inférieures les plus petites celle qui est la plus critique et qui devient ladite cellule nominale.

8. Produit programme d'ordinateur comprenant un jeu d'instructions qui, lorsqu'il est exécuté par des moyens de traitement, conduisent ceux-ci à mettre en œuvre le procédé d'estimation selon l'une des revendications 1 à 7, dans un véhicule (V) comprenant une batterie (BC) comportant N cellules, pour estimer un état de charge de ladite batterie (BC).

9. Dispositif d'estimation (DE) pour estimer un état de charge d'une batterie (BC) comprenant N cellules et équipant un véhicule (V), le dispositif comprenant au moins un processeur (PR1) et au moins une mémoire (MD) agencés pour effectuer les opérations consistant i) à identifier parmi lesdites N cellules M cellules dites critiques, puis ii) à déterminer pour chacune desdites M cellules critiques identifiées et selon une première période d'échantillonnage, un état de charge par application à un modèle de cellule choisi d'un premier filtre choisi utilisant des impédance et capacité mesurées de la cellule considérée, puis à sélectionner une cellule dite nominale parmi lesdites M cellules critiques identifiées, puis iii) pour chacune des N-M cellules non critiques, à déterminer, selon une seconde période d'échantillonnage supérieure à ladite première période d'échantillonnage et par application audit modèle de cellule choisi d'un second filtre choisi, une nouvelle différence d'état de charge fonction d'une précédente différence d'état de charge, d'un courant mesuré dans ladite batterie (BC), d'une capacité mesurée de la cellule non critique considérée et de la capacité mesurée de ladite cellule nominale, puis un nouvel état de charge en sommant ledit état de charge déterminé de ladite cellule nominale et ladite nouvelle différence d'état de charge, et iv) à déterminer selon ladite seconde période d'échantillonnage ledit état de charge de la batterie (BC) en exploitant lesdits nouveaux états de charge déterminés des N-M cellules non critiques et lesdits états de charge déterminés des M cellules critiques.

10. Véhicule (V) comprenant une batterie (BC) comportant N cellules, **caractérisé en ce qu'**il comprend en outre un dispositif d'estimation (DE) selon la revendication 9.

## Patentansprüche

1. Verfahren zum Schätzen eines Ladezustands einer Batterie (BC), die N Zellen umfasst und mit einem Fahrzeug (V) ausgestattet ist, wobei das Verfahren einen Schritt (10-40) umfasst, bei dem i) man aus den N Zellen M kritische Zellen identifiziert, dann ii) für jede der M identifizierten kritischen Zellen und in einer ersten Abtastperiode einen Ladezustand bestimmt, indem man auf ein ausgewähltes Zellmodell eines ersten ausgewählten Filters unter Verwendung der gemessenen Impedanz und Kapazität der betrachteten Zelle anwendet, dann eine so genannte nominelle Zelle aus den M identifizierten kritischen Zellen auswählt, und dann iii) für jede der N-M nicht kritischen Zellen bestimmt, Gemäß einer zweiten Abtastperiode, die größer als die erste Abtastperiode ist, und durch Anwenden eines zweiten ausgewählten Filters auf das ausgewählte Zellenmodell, eine neue Ladungszustandsdifferenz, die von einer vorhergehenden Ladungszustandsdifferenz, einem in der Batterie (BC) gemessenen Strom, einer gemessenen Kapazität der betrachteten nicht kritischen Zelle und der gemessenen Kapazität der Nennzelle abhängt, dann ein neuer Ladungszustand durch Summieren des bestimmten Ladungszustands der Nennzelle und der neuen Ladungszustandsdifferenz, und iv) gemäß der zweiten Abtastperiode wird der Ladungszustand der Batterie (BC) bestimmt, indem die neuen bestimmten Ladungszustände der N-M nicht-Zellen ausgenutzt werden Kritische Zellen und die ermittelten Beladungszustände der M kritischen Zellen.

2. Verfahren nach Anspruch 1, **dadurch gekennzeichnet, dass** in dem Schritt (10-40) das erste ausgewählte Filter ein Kalman-Filter ist, das in zwei Zuständen erweitert ist, wobei ein erster Zustand der Ladezustand der betrachteten kritischen Zelle ist und ein zweiter Zustand eine Vorspannung der betrachteten kritischen Zelle ist.

3. Verfahren nach Anspruch 1 oder 2, **dadurch gekennzeichnet, dass** in dem Schritt (10-40) das zweite ausgewählte Filter ein Kalman-Filter ist, das in einen Zustand erweitert wird, wobei dieser Zustand der Ladezustand der betrachteten nicht kritischen Zelle ist.

4. Verfahren nach einem der Ansprüche 1 bis 3, **dadurch gekennzeichnet, dass** in dem Schritt (10-40) das ausgewählte Zellenmodell ein äquivalentes elektrisches Schaltungsmodell n-RC mit n ≥ 1 ist.

5. Verfahren nach einem der Ansprüche 1 bis 4, **dadurch gekennzeichnet, dass** in dem Schritt (10-40) eine zweite Abtastperiode verwendet wird, die gleich K mal der ersten Abtastperiode ist, wobei K eine Anzahl von Gruppen ist, in denen die N-M nicht-kritischen Zellen verteilt sind, und dass in jeder ersten Abtastperiode die neuen Ladezustände der nicht-kritischen Zellen einer der K Gruppen bestimmt werden, um die N-M neuen Ladezustände der N-M nicht-kritischen Zellen am Ende jeder zweiten Abtastperiode anzuordnen.

6. Verfahren nach einem der Ansprüche 1 bis 5, **dadurch gekennzeichnet, dass** in dem Schritt (10-40) die M kritischen Zellen ausgewählt werden, indem unter den N Zellen diejenigen bestimmt werden, die die M/2 oberen Betriebsgrenzen und diejenigen, die die M/2 unteren Betriebsgrenzen haben, die kleinsten im Verhältnis zu vorbestimmten Betriebsgrenzen.

7. Verfahren nach Anspruch 6, **dadurch gekennzeichnet, dass** in dem Schritt (10-40) unter den M/2 kritischen Zellen mit den M/2 oberen Betriebsgrenzen die größten und unter den M/2 kritischen Zellen mit den unteren Betriebsgrenzen die kleinste bestimmt wird, die die kritischste Zelle ist und die zur nominalen Zelle wird.

8. Computerprogrammprodukt, das einen Satz von Befehlen umfasst, die, wenn sie durch Verarbeitungsmittel ausgeführt werden, diese veranlassen, das Schätzverfahren nach einem der Ansprüche 1 bis 7 in einem Fahrzeug (V), das eine Batterie (BC) mit N Zellen umfasst, zu implementieren, um einen Ladezustand der Batterie (BC) zu schätzen.

9. Schätzvorrichtung (DE) zum Schätzen eines Ladezustands einer Batterie (BC), die N Zellen umfasst und mit einem Fahrzeug (V) ausgestattet ist, wobei die Vorrichtung mindestens einen Prozessor (PR1) und mindestens einen Speicher (MD) umfasst, die so angeordnet sind, dass sie die Operationen i) identifizieren von den N Zellen M kritische Zellen, und ii) für jede der M identifizierten kritischen Zellen und in einer ersten Abtastperiode einen Ladezustand bestimmen, indem ein ausgewähltes erstes Zellmodell unter Verwendung der gemessenen Impedanz und Kapazität der betreffenden Zelle angewendet wird, und dann eine so genannte nominale Zelle auswählen die M identifizierten kritischen Zellen, dann iii) für jede der N-M nicht-kritischen Zellen, die in einer zweiten Abtastperiode, die größer als die erste Abtastperiode ist, und durch Anwendung eines zweiten ausgewählten Filters auf das ausgewählte Zellmodell eine neue Ladungszustandsdifferenz zu bestimmen, die von einer vorhergehenden Ladungszustandsdifferenz, einem in der Batterie (BC) gemessenen Strom, einer gemessenen Kapazität der betreffenden nicht-kritischen Zelle und der gemessenen Kapazität der genannten nominalen Zelle abhängt, dann einen neuen Ladungszustand durch Summierung des genannten bestimmten Ladungszustands der genannten nominalen Zelle und der genannten neuen Ladungszustandsdifferenz, und iv) gemäß der genannten zweiten Abtastperiode zu bestimmen Batterieladezustand (BC) unter Auswertung der ermittelten neuen Ladezustände der N-M nicht kritischen Zellen und der ermittelten Ladezustände der M kritischen Zellen.

10. Fahrzeug (V) mit einer Batterie (BC) mit N Zellen, **dadurch gekennzeichnet, dass** es ferner eine Abschätzvorrichtung (DE) nach Anspruch 9 aufweist.

## Claims

1. Method for estimating a state of charge of a battery (BC) comprising N cells and fitted to a vehicle (V), the method comprising a step (10 - 40) in which i) said N cells M called critical cells are identified, then ii) for each of said M identified critical cells and according to a first sampling period, a state of charge is determined by application to a selected cell filter of a first selected in using measured impedances and capacity of the cell in question, then a so-called nominal cell said M identified critical cells is selected, then iii) for each of the N-M non-critical cells, a new in filter difference is determined according to a second sampling period greater than said first sampling period and by application to said selected cell model of a second selected status, as a function of a load difference in previous status measured in said battery, (BC), of a measured loads of the non-critical cell considered and of the measured current of said nominal cell, then a new state of charge by summing said determined state of charge of said nominal cell and said new status loads difference, and iv) said battery charge status (BC) is determined according to said second sampling period by using said new load of determined status of the N-M non-critical cells and said determined state of charge of the M critical cells.

2. The method according to claim 1, wherein in said step (10 - 40) said first chosen filter is a two-status extended Kalman filter, a first status being the state of charge of the critical cell considered and a second status being a bias voltage of the critical cell considered.

3. Method according to claim 1 or 2, wherein in said step (10-40) said second selected filter is a Kalman filter extended to a status, this status being the state of charge of the non-critical cell considered.

4. Method according to one of Claims 1 to 3, **characterised in that** in said step (10-40) said chosen cell model is an equivalent electrical circuit model n-RC, with n ≥ 1.

5. Method according to one of claims 1 to 4, wherein in said step (10-40) a second sampling period equal to K times said first sampling period is used, where K is a quantity of groups in which said N-M non-critical cells are distributed, and the new states of charge of the non-critical cells of one of said K groups are determined during each first sampling period so as to dispose of said N-M new states of charge of said N-M non-critical cells at the end of each second sampling period.

6. Method according to one of Claims 1 to 5, **characterised in that** in said step (10-40) said M critical cells are selected by determining said N cells those which have the largest M/2 upper operating limits and those which have the smallest M/2 lower operating limits by report with predefined operating limits.

7. Method according to claim 6, **characterised in that** in said step (10-40) said M/2 critical cells having said M/2 largest upper operating limits and said M/2 critical cells having said M/2 lowest operating limits are determined the one which is the most critical and which becomes said nominal cell.

8. Computer Plan Product comprising a set of instructions which, when executed by processing means, lead the latter to implement the estimation method according to one of claims 1 to 7, in a vehicle (V) comprising a battery (BC) comprising N cells, to estimate a state of charge of said battery (BC).

9. An estimation device (DE) for estimating a state of charge of a battery (BC) comprising N cells and equipping a vehicle (V), the device comprising at least one processor (PR1) and at least one memory (MD) arranged to perform the tasks consisting of i) identifying said N cells M so-called critical cells, then ii) determining for each of said M identified critical cells and according to a first sampling period, a state of charge by application to a selected cell model of a first selected filter using measured impedances and capacity of the cell considered, then selecting a so-called nominal cell {circumflex over (B)} said M identified critical cells, then iii) for each of the N-M non-critical cells, determining, according to a second sampling period greater than said first sampling period and by application of said selected in of a new in difference of filter, as a function of a status load previous difference, of a status measured in said battery (BC), of a measured loads of the non-critical cell considered and of the measured current of said nominal cell, then a new state of charge by summing said determined status loads of said nominal cell and said new status loads difference, and iv) to be determined according to said second sampling period said charge status of the battery (BC) by exploiting said new determined states of charge of the N-M non-critical cells and said determined state of charge of the M critical cells.

10. Vehicle (V) comprising a battery (BC) comprising N cells, **characterised in that** it further comprises an estimation device (DE) according to claim 9.
